# EUROPÄISCHE PATENTSCHRIFT

(11) **EP 2 767 989 B1**
(45) Veröffentlichungstag und Bekanntmachung des Hinweises auf die Patenterteilung: **10.02.2016**
(21) Anmeldenummer: 14154466.8
(22) Anmeldetag: 10.02.2014
(51) Int. Cl.: H01F 6/04, F17C 7/02, G01R 33/38, H01F 6/02

(54) **Vorrichtung zur Entnahme von flüssigem Helium aus einem Magnetresonanztomographen**
Device for removal of liquid helium from a magnetic resonance tomograph
Dispositif de prélèvement d'hélium liquide à partir d'un tomographe à résonance magnétique

(30) Priorität: 14.02.2013 EP 13000748
(43) Veröffentlichungstag der Anmeldung: 20.08.2014
(73) Patentinhaber: Bruns, Axel, 71229 Leonberg-Gebersheim (DE)
(72) Erfinder: Bruns, Axel, 71229 Leonberg-Gebersheim (DE)
(74) Vertreter: Spachmann, Holger

(56) Entgegenhaltungen:
- EP-A2- 1 327 817
- FR-A1- 2 188 094
- FR-A1- 2 752 037
- JP-A- 2003 042 396
- US-A- 3 430 450
- US-A1- 2011 312 502

## Beschreibung

Die Erfindung betrifft eine Liquid Helium Entfüllungs-Vorrichtung, die ermöglicht, flüssiges Helium aus Tieftemperaturmagneten mit einer geometrisch komplexen Gehäuseform zurück zu gewinnen, um die Ressource Helium zu sparen und bei Zwischenfällen die Tieftemperaturmagneten schneller wieder in Betrieb zu nehmen.

Die vorliegende Erfindung bezieht sich auf eine Vorrichtung und ein Verfahren, Helium in flüssiger Form ohne Durchführung eines Quench, vorzugsweise bei Magnetresonanztomographen (MRT/MRI) oder anderen Hochfeldmagneten, in Dewar-Kannen oder ähnlichen Transportbehältnisse kontrolliert zurück zu führen.

### STAND DER TECHNIK

Die Magnetresonanztomographie ist ein bildgebendes Verfahren, das vor allem in der medizinischen Diagnostik zur Darstellung von Struktur und Funktion der Gewebe und Organe im Körper eingesetzt wird. Es basiert physikalisch auf den Prinzipien der Kernspinresonanz (NMR), und wird auch als Kernspintomographie bezeichnet. Für eine Kernspinnresonanz werden Atomkerne einer Materialprobe in einem konstanten Magnetfeld hoher Stärke durch Absorption eines elektromagnetischen Wechselfelds im Bereich einer spezifischen Resonanzfrequenz angeregt, selbst elektromagnetische Felder zu emittieren. Die dabei ermittelbare Resonanzfrequenz ist proportional zur Stärke des Magnetfelds am Ort des Kerns und zum Verhältnis des magnetischen Dipolmoments des Kerns zu seinem Spin. Die Amplitude des gemessenen Signals ist proportional zur Konzentration der betreffenden Art von Kernen in der Probe, wodurch auf die Verteilung verschiedener Atome in der Probe rückgeschlossen werden kann. Die Amplitude und besonders die Frequenz der Kernspinresonanz sind mit sehr hoher Genauigkeit messbar. Dies gestattet detaillierte Rückschlüsse sowohl auf den Aufbau der Kerne als auch auf ihre sonstigen Wechselwirkungen mit der näheren und weiteren atomaren Umgebung.

Für die Erzeugung der hierfür notwendigen extrem starken Magnetfelder von 0.5 bis 10 Tesla werden in MRTs stromdurchflossene Zylinderspulenspulen, sogenannte Solenoide eingesetzt, die mit großen Stromstärken durchflossen werden. Zur Erhöhung der Leitfähigkeit dieser Spulen und zur Senkung des elektrischen Verbrauchs werden in der Regel supraleitende Magnetfeldspulen eingesetzt. Supraleitende Spulen weisen die Eigenschaft auf, dass deren elektrischer Widerstand unterhalb einer Sprungtemperatur auf Null abfällt, und somit keine thermischen Verluste auftreten und mit relativ geringer elektrischer Energie starke Magnetfelder erzeugt werden können. In konventionellen MRTs erfolgt die Kühlung der elektrischen Spulen mit Hilfe von Tieftemperaturflüssigkeit, insbesondere von flüssigem Helium bei Temperaturen von ca. -269°C (ca. 4.2°K) in der Nähe des absoluten Nullpunktes

Wenn Heliumgas höherer Temperatur auf einen Tieftemperaturmagneten trifft, bei der noch die Möglichkeit einer Supraleitung besteht, besteht die Gefahr, bei Reaktion die Erzeugung eines Quench hervorzurufen, d.h. ein schlagartiges Verdampfen des flüssigen Heliumbestands. In dem Fall wird die gespeicherte Energie des Tieftemperaturmagneten frei, und das Magnetfeld fällt in sich zusammen und wird unmagnetisch. Bei einem Quench erfolgt ein plötzlicher Übergang der Magneten eines MRTs vom supraleitenden in den normalleitenden Zustand infolge Überschreitung einer Supraleitungs-Sprungtemperatur. Hierbei entstehen auf Grund des nun endlichen Widerstandes hohe Spannungen und sehr viel Wärme, was zu Überschlägen durch die elektrische Isolation und in seltenen Fällen bis zur Zerstörung des Supraleiters führen kann. Das dabei verdampfende Kühlmittel kann durch den entstehenden Überdruck den MRT-Kryostatcontainer sprengen. Beim Zusammenbruch der Supraleitung kann die Feldenergie der Magneten schlagartig in Wärme umgesetzt werden.

Der bisherige Stand der Technik hat gerade im medizinischen Bereich gezeigt, dass durch Unachtsamkeit öfter magnetische Metallteile in den Untersuchungsraum bei MRT/ MRI-Anlagen eingebracht wurden. Angefangen von Schraubenschlüsseln bis zu Sauerstoffbeatmungsgeräten sind schon viele Teile an/in die 'Röhre' gezogen worden und konnten nicht mehr gelöst werden. Um jedoch nun die metallischen Objekte aus dem Magnetfeldbereich zu entfernen, wird es notwendig, den Tieftemperatur-Magneten durch einen künstlich hervorgerufenen Quench zu entmagnetisieren, um das metallische Objekt aus der Untersuchungs-, Forschungs-Röhre zu entfernen. Nach einem Quench muss der Solenoid wieder herunter gekühlt werden, was einen erhöhten Bedarf an flüssigem Helium erfordert. Zusätzlich muss zum Downcooling wieder der optimale Betriebsmittel-Pegel des Helium-Bestands bei solch einer Anlage hervorgerufen werden, um den sicheren Betrieb der Anlage zu gewährleiten.

Auf Grund der immer größer werdenden Knappheit des weltweit verfügbaren Heliums, und der Tatsache, dass sich die Technologie bei der MRT-Technik in den letzten 30 Jahren nicht sonderlich viel im Bereich des MRT-LHe-Reservoirs geändert hat, ist es gerade durch diese Vorrichtung möglich, die Ressource flüssiges Helium für die nächsten Jahrzehnte für ionisierungsstrahlungsfreie Untersuchungstechniken zu bewahren. Zusätzlich ist zu beachten, dass Helium auf Grund seiner geringen Dichte die Atmosphäre der Erde verlässt und somit unwiederbringlich verschwindet.

In der JP 2003 042396A ist ein Verfahren zur Entfüllung eines Helium-Transportbehälters mit flüssigem Helium angegeben, bei dem Helium durch Einpressen eines Hebergases wie Luft in einen oberen Bereich eines LHe-Transportbehälters in ein Anwendungsgefäß, Beispielsweise ein Magnetspulengefäß, umgefüllt werden kann. Hierzu wird in den Transportbehälter eine Hebergasleitung und parallel hierzu eine LHe-Sammelleitung eingebracht. Die Hebergasleitung reicht in einen oberen Bereich, die LHe-Sammelleitung in einen unteren Bereich des Transportbehälters. Es wird kein Hinweis gegen, wie eine derartige Vorrichtung für einen Entfüllung eines MRTs umgesetzt werden kann.

Die FR 2 188 094 A betrifft eine gattungsgemäße LHe-Entfüllungsvorrichtung für einen Dewargefäß.

Schließlich betrifft die US 2011/312502 A ebenfalls eine Dewar-Entfüllungsvorrichtung, die dazu geeignet ist, LHe aus einem Transportbehälter zu entfüllen, und in einen Container eines MRTs einzufüllen.

Keine der aus dem Stand der Technik bekannten Druckschriften diskutieren Möglichkeiten zur Entleerung eines MRT-Containers, da dieser aufgrund seiner Struktur eines Zylindermantels geometrisch komplex ist. Daher war es bisher unmöglich, in einem komplexen Zylindermantel bereits bei der Konstruktion als auch bei bereits bestehenden MRTs eine Entfüllungsvorrichtung vorzusehen, die eine einzige Stelle der Containerwand, beispielsweise einem Einfüllflansch oder einem Flansch eines Kühlkopfes nutzt, um eine LHe-Sammelleitung und eine Hebergas-Zuführleitung derart zu positionieren, dass eine restlose Entfüllung des MRTs möglich scheint. Daher wurde bisher das Helium im Falle einer Entleerung ungenutzt an die Umwelt abgebeben z.B. durch zeitaufwändiges Verdampfen entweichen lassen, wobei das rare Helium einer Wiedernutzung nicht zur Verfügung stand.

Aufgabe der Erfindung ist es, eine Entfüllungsvorrichtung für Helium aus existierenden MRTs oder zukünftig zu bauende MRTs vorzuschlagen, die ein einfaches, zeiteffizientes und gefahrloses Entfüllen von flüssigem Helium aus einem MRT ermöglicht, so das das LHe zur Weiternutzung zur Verfügung steht. Gelöst wird die obengenannte Aufgabe durch eine LHe-Entfüllungsvorrichtung nach der Lehre des unabhängigen Anspruchs. Vorteilhafte Ausführungsformen der Erfindung sind Gegenstand der abhängigen Ansprüche.

### OFFENBARUNG DER ERFINDUNG

Erfindungsgemäß wird eine Helium-Entfüllungsvorrichtung zur Rückgewinnung von flüssigem Helium (Liquid Helium - LHe) aus Tieftemperaturmagneten von Magnetresonanztomographiegeräten (MRTs) vorgeschlagen, die eine an einer Oberfläche eines Containers eines MRTs befestigte Kopplungseinheit zur Ausbildung einer zweikanalige Anschlussstelle für eine Hebergas-Zuführungsleitung an eine Hebergasflasche und eine LHe-Abführleitung an einen temperaturisolierten Helium-Transportbehälter umfasst.

Es wird vorgeschlagen, dass die Kopplungseinheit in Richtung des Containerinneren einen Anschluss oder eine Verbindung zu einer Hebergas-Steigleitung in Richtung eines oberen Abschnittsbereichs des Containers des MRTs und einen Anschluss oder eine Verbindung zu einer LHe-Sammelleitung in Richtung eines unteren Abschnittsbereiches des Containers zur Sammlung und Abführung des LHe umfasst.

Hierbei ist eine Hebergas-Steigleitung im Inneren des MRTs durch die Kopplungseinheit mit einer Hebergas-Zuführleitung am Ausgang des magnetisch abgeschirmten Bereichs verbunden. Ebenso ist eine LHe-Abführleitung durch die Kopplungseinheit mit einer LHe-Sammelleitung im Inneren des Containers verbunden, so dass der Heliumbestand aus dem LHe-Reservoir nach außen in ein Dewargefäß geleitet werden kann. Das Hebergas kann Druckluft oder ein anderes Gas, CO2 oder ähnliches sein, insbesondere ein Gas mit einem sehr niedrigen Kondensationspunkt und unter hohem Druck. Die Druckgasleitung ist im oberen Bereich des Tieftemperaturmagneten angeordnet. Das Druckgas wird über die Kopplung zugeführt, dass über den Anschluss eingeleitet wurde. Über die Flüssiggasleitung wird durch den durchgeführten Druckaufbau das Helium an der Kopplung am Anschluss aus dem Tieftemperaturmagneten herausgeführt. Die verwendeten Leitungen im Inneren des Containers sind vorzugsweise aus einem nichtmagnetischen Material, insbesondere Titan oder unmagnetischem Stahl gefertigt.

Vorzugsweise kann durch eine innere Wand des Tieftemperaturmagneten der flüssige Bestandteil des Heliums entnommen werden. Dieser kann aus einem Abfluss aufgenommen und durch eine Sammelleitung aufgenommen werden. Über die Außenseite wird Druckgas / Hebergas eingeleitet, und führt zur Leitungsöffnung.

Erfindungsgemäß verläuft ausgehend von der Kopplungseinheit im Inneren des MRT-Containers die LHe-Sammelleitung nicht parallel zur Hebergasleitung. Die beiden Leitungen sind abgewinkelt, um dem komplexen inneren des MRTs zu entsprechen und in der Containerinnenwandung des Hohlzylindermantels geführt zu werden.

Hierdurch verläuft die LHe-Sammelleitung von der Hebergas-Steigleitung abgewinkelt, und weist einen geometrisch komplexen, abgewinkelten oder gekrümmten Führungsverlauf auf oder ist flexibel ausgelegt, um einer Rundung des Zylindermantels des MRT-Containers in Richtung zu einem tiefsten Punkt des Containers zu folgen. Zusätzlich oder alternativ weist ausgehend von der Kopplungseinheit im Inneren des MRT-Containers die Hebergas-Steigleitung einen geometrisch komplexen, abgewinkelten oder gekrümmten Führungsverlauf auf oder ist flexibel ausgelegt, um einer Rundung des Zylindermantels des MRT-Containers in Richtung eines höchsten Punktes des MRT-Containers zu folgen.

In einer vorteilhaften Weiterbildung kann die Vorrichtung eine Grundplatte umfassen, die an einem Flansch des MRT-Containers, insbesondere eines Heliumeinfüllflansches befestigbar ist, wobei bevorzugt eine oder mehrere kreis- oder rechteckige Adapterringe umfasst sind, um die Grundplatte an verschiedene Flanschgrößen anpassbar zu machen. Dieses Ausführungsbeispiel betrifft eine mechanische mobile Vorrichtung zur Rückgewinnung von flüssigem Helium aus Tieftemperaturmagneten älteren Baujahren, um die Ressource Helium zu sparen und bei Zwischenfällen die Tieftemperaturmagneten schneller wieder in Betrieb zu nehmen, da mit dieser Vorrichtung die Durchführung eines Quench überflüssig wird.

Vorzugsweise ist eine mobile Vorrichtung für jeden Typus für Tieftemperatur-magneten geeignet, die keine fest verbaute Entfüllungsvorrichtung aufweist Die Tragelaschen sind an der Kopplungsplatte für den Transport befestigt. Ebenfalls befinden sich an der Kopplungsplatte zahlreiche Befestigungspunkte, die mit dem Tieftemperaturmagneten verbunden werden, dass es eine dichte Verbindung gibt. Ist die Verbindung aufgebaut, werden nun die Führungsleitungen, Druckgas-Zuführungsleitung und LHe-Abführleitung angeschlossen. Nach der Entriegelung der Ventilhebel können die Hebel in die Öffnungsposition gebracht werden. Eine Kopplungsplatte kann in unterschiedlichen Größen gearbeitet werden. Um das Helium aus dem Tieftemperaturmagneten herauszuführen wird in der Leitung der Anschluss an das innere Leitungssystem durchgeführt. Über einen Sammel- oder Gewindekegel wird dann das Helium aus dem Tieftemperaturmagneten herausgeführt über die Liquid Helium führende Sammelleitung. Auf Grund unterschiedlicher inneren Bauweisen der Tieftemperaturmagneten können die Hebersteigleitung und LHe-Sammelleitung in der Länge variieren. Bei Altmagneten kann die LHe-Sammelleitung bis zum Boden des LHe-Reservoirs durchgeschoben werden.

Alternativ kann in einer vorteilhaften Weiterbildung kann die Vorrichtung eine Grundplatte umfassen, die einstückig und unlösbar an oder in einer Wandung des MRT-Containers, bevorzugt an einem Seitenwandabschnitt des MRT-Containers befestigt ist. Dieses Ausführungsbeispiel betrifft eine mechanische verbaute Vorrichtung zur Rückgewinnung von flüssigem Helium aus Tieftemperaturmagneten, um die Ressource Helium zu sparen und bei Zwischenfällen die Tieftemperaturmagneten schneller wieder in Betrieb zu nehmen, da mit dieser Vorrichtung die Durchführung eines Quench überflüssig wird.

In einer vorteilhaften Weiterbildung kann die Grundplatte zwei Anschlüsse für die Hebergas-Zuführungsleitung und die LHe-Abführleitung umfassen, wobei die Anschlüsse durch eine Abstandsplatte beabstandet und durch Befestigungsmittel am Container bzw. an der Grundplatte befestigt sind. Vorzugsweise kann die Druckgas-Zuführleitung und die LHe-Abführleitung durch Halterplatten und fixiert werden können, und durch Befestigungen, befestigt werden.

In einer vorteilhaften Weiterbildung kann der Endbereich der LHe-Sammelleitung in eine Vertiefung oder eine rampenförmig definierten tiefsten Bereich oder Abflussbereich des Containerinnenraums geführt sein. Die Abflussleitung, die zur Kopplung führt, sollte vorzugsweise eine Verbindung zum Abfluss haben kann. Zur besseren Sammlung von Flüssigkeiten kann ein Gefälle bei der Tieftemperaturmagnetfertigung den Ertrag des zu entnehmenden flüssigem Helium verbessern, da der Sammelpunkt zum Abfluss führt.

In einer vorteilhaften Weiterbildung kann die Kopplungseinheit zumindest ein Sicherheitsrückschlagventil umfassen, um Druck aus der Hebergas-Zuführungsleitung und/oder aus der Hebergas-Steigleitung zu blockieren, so dass die Leitung gefahrlos anschließbar ist. Es kann an der Zuführung ein Sicherheitsrückschlagventil befestigt sein, um den Druck aus der Leitung zu nehmen, um gefahrlos den Anschluss der Druckgas-Leitung an der Kopplung anzuschließen. Nach Druckaufbau kann über die Abflussleitung entnommen werden. Über den Abfluss wird das flüssige Helium durch den Druck aus dem System herausgeführt.

In einer vorteilhaften Weiterbildung kann zumindest die LHe-Sammelleitung eine flexible Leitung, insbesondere eine Metallschlauchleitung, Gummileitung oder andere flexible Tieftemperaturleitung sein, die bevorzugt an der Einlassöffnung einen Sammelkegel aufweisen. Vorteilhafterweise besteht der Metallanteil aus einem nichtmagnetischen Material wie Titan. Vorteilhaft kann bei einem Bestands- oder Alt-MRT über einen Sammel- oder Gewindekegel das flüssige Helium über eine Sammelleitung zur Kopplung geführt werden, wenn gleichzeitig Hebergas über die Steigleitung eingepresst wird. Dies kann nach Durchschiebung einer flexiblen Sammelleitung auf den Grund des Liquid Helium-Reservoirs erfolgen.

In einer vorteilhaften Weiterbildung kann die LHe-Sammelleitung eine fest an einer Innenwandung des MRT-Containers verlegte Leitung sein, die zu einem tiefsten Punkt des Containers geführt ist und/oder kann die Hebergas-Steigleitung eine fest an einer Innenwandung des MRT-Containers verlegte Leitung sein, die zu einem höchsten Punkt des Containers geführt ist.

In einer vorteilhaften Weiterbildung kann die Kopplungseinheit ein zumindest händisch betätigbares Hebergas-Zuführventil und zumindest ein händisch betätigbares LHe-Abführventil umfassen. Vorzugsweise umfasst die Kopplungseinheit Hebel, die ein Öffnen und Schließen ermöglichen. Hierbei sind zwei verschiedene Stellungen der Hebel möglich, ein geöffneter und ein geschlossener. Der geschlossene Zustand verhindert ein Eindringen des Druckgases und ein Ausströmen des flüssigen Heliums. Diese Position kann aus Sicherheitsgründen nicht verändert werden, wenn die Anschlüsse nicht freigegeben wurden. Sind die Sicherheitsanschlüsse freigegeben, können die Hebel unabhängig voneinander in die Positionen und gebracht werden. Dies ist z.B. in der Anwendung nützlich, wenn die Druckgasflasche getauscht werden muss, und durch den Restdruck das Helium noch weiter in das Transportbehältnis überführt wird. Die Fließrichtungen sind in den beigefügten Figuren durch Pfeile der Druckgaszuführung und der LHe-Abflussrichtung gekennzeichnet. Die Vorrichtung an der Außenseite wird über Befestigungsmittel wie Schrauben oder Nieten befestigt und in Position gehalten.

In einer vorteilhaften Weiterbildung kann zumindest das Hebergas-Zuführventil und/oder das LHe-Abführventil ein oder mehrere Sicherheits-Verriegelungselemente umfassen, die eine Betätigung erst nach Anschluss der Herbergas-Zuführungsleitung und/oder des LHe-Abführleitung ermöglichen. Ein Öffnen und Schließen der Hebel ist möglich wenn die Sicherheitsarretierung freigegeben wurde. Erst dann kann der Fluss der Gase in flüssiger Form und gasförmiger Form erfolgen, die dann über die Abflussleitung und der Zuflussleitung angeschlossen werden. Die Ventile können nur den Fluss ermöglichen, wenn der Stopfen und die Sicherheitsarretierung freigegeben haben.

Gemäß der vorliegenden Erfindung, die sich in zwei Teile gliedert, einer mobilen Vorrichtung und einer Vorrichtung, die direkt bei der Herstellung der Magnete verbaut werden kann, ist es nun erstmals möglich, Helium in flüssiger Form aus den Tieftemperatur-Magneten zurück zu gewinnen. Diese Erfindung macht es möglich, durch ein gezieltes Absenken des Pegels das Magnetfeld zu senken und metallische Objekte aus dem Magneten zu entfernen, ohne dass ein Quench des Magneten durchgeführt werden muss. Zudem kann im Anschluss über Hebergasleitungen das entnommene Helium dem Kreislauf mit sehr geringen Abdampfungsverlusten wieder zugeführt werden. Diese Vorrichtung spart erhebliche Kosten und zwar die für eine Neubefüllung und die für ein Downcooling, um den Magneten wieder in den supraleitenden Zustand zu bringen. Weiterer Vorteil dieser Erfindung ist, dass dieser Magnet nach der Rück-Kopplung am gleichen Tag wieder einsatzbereit ist, ohne die üblichen ein bis zwei Wochen Lieferzeit von flüssigem Helium.

Weiterer Vorteil der Erfindung ist z.B. im Falle einer Außerbetriebnahme des Tieftemperaturmagneten, dass der Helium-Restbestand (in der Regel zwischen 500 bis 1000 Liter) nicht mehr wie üblich abgedampft werden muss, um den Magneten transportfähig zu machen. Dieser Restbestand kann zurück gewonnen werden und bei anderen Tieftemperaturmagneten wieder weiterverwendet werden. Diese Tatsache und die Tatsache des begrenzten Vorhandenseins von Helium in flüssiger Form zeigen ganz deutlich, wie wichtig diese Erfindung für forschungs- und medizinisch-genutzten Magneten ist.

Funktion und Aufbau. Bei der herkömmlichen Befüllung wird mit sog. Hebergas, d.h. Heliumdampf, in der Dewarkanne ein Druckaufbau erzeugt. Dieser Druck drückt das flüssige Helium in das Helium-Reservoir des Magneten. Der Magnet an sich ist ein abgeschlossenes System, ähnlich einer "Wasserflasche", d.h. wird befüllt und kann nur durch Quench entleert werden. Diese Erfindung ist eine Art Strohhalm, in der man in umgekehrter Richtung das Helium wieder heraus bekommt. Mit dieser Vorrichtung wird ebenfalls Hebergas verwendet und in das Reservoir des Magneten geleitet. Der Druckaufbau sorgt dafür, dass über eine gesonderte Leitung der flüssige Bestandteil dem Magnet-System wieder entnommen werden kann, um dieses anderweitig zu verwenden, oder nach entfernen eines Fremdkörpers wie bei der Befüllung wieder zugeführt werden kann.

Funktionsaufbaubeschreibung der fest verbauten Entfüllungsvorrichtung für Neugeräte. Über einen seitlichen Zugang werden bei der Fertigung des MR-Gerätes zwei Leitungen verlegt. Eine Leitung führt zum oberen Bereich. Über diese nach oben führende Leitung wird Hebergas eingeleitet und sorgt somit für den Druckaufbau im Tieftemperaturmagneten. Die zweite Leitung führt zum Boden, d.h. nach unten innerhalb dieses Reservoirs. Ist nun Druck über die Hebergasflasche aufgebaut, kann durch Hahnöffnung kontrolliert das flüssige Helium aus der Leitung in die isolierten Dewar-Kannen, d.h. Transportbehältnisse, abgeführt werden, entweder zur Weiterverwendung oder Wiederbefüllung nach einem Zwischenfall. (Näheres zum Aufbau und zur Funktion siehe Beschreibung der Patentansprüche mit den Figur-Erläuterungen)

Funktionsaufbaubeschreibung der mobilen, d.h. nicht verbauten Entfüllungsvorrichtung. Da nun bei allen noch derzeitig existierenden Geräten keine fest verbaute Variante der Entfüllungsvorrichtung existiert, muss hierfür auch eine Lösung gefunden werden. Die mobile Vorrichtung funktioniert nach dem gleichen Prinzip wie die fest verbaute Vorrichtung. Im Gegensatz zur fest verbauten Vorrichtung wird das mobile Teil entweder auf den bereits vorhandenen Befüllungsanschlussflansch gesetzt, oder anstelle des bereits verbauten Kaltkopfes gesetzt. Der Kaltkopf hat die Funktion, das gasförmige Helium wieder in flüssiges Helium zu kondensieren. Daher existieren mind. eine Flüssigleitung und eine Gasleitung. Diese sind in dem Fall zu verwenden. Der Kaltkopf drückt kontinuierlich das verflüssigte Helium in den Kreislauf zurück und nimmt im Gegenzug das gasförmige Helium zur Kondensation an. Nun wird die mobile Vorrichtung verbaut und die Flüssigleitungen und Gasleitungen werden mit der Vorrichtung verbunden. Über Hebergas wird nun Druck im System erzeugt, der in umgekehrter Richtung den flüssigen Bestandteil aus dem System herausführt, und in die dafür vorgesehenen Transportbehältnisse leitet. Ab diesem Moment kann das abgeführte flüssige Helium weiter verwendet oder nach Entfernung des Fremdkörpers wieder dem System zugefügt werden, um die volle Leistungsfähigkeit wieder zu erzielen.

### ZEICHNUNGEN

Weitere Vorteile ergeben sich aus der vorliegenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- **Fig. 1**: Schematische Darstellung einer ersten Ausführungsform 100 einer Entfüllungsvorrichtung;
- **Fig. 2**: Perspektivische Darstellung des ersten Ausführungsbeispiels 100 der Entfüllungsvorrichtung;
- **Fig. 3**: Schematische Darstellung der ersten Ausführungsform 100 einer erfindungsgemäßen Entfüllungsvorrichtung in einer Seitendarstellung,
- **Fig. 4**: Eine Schnittansicht durch die Fig. 3. auf einen Boden eines MRT-Zylinders mit "Abfluss";
- **Fig. 5**: Längsschnitt-Ansicht durch eine Kopplungseinheit im Inneren einer Seitenwand des MRTs gemäß des ersten Ausführungsbeispiels der Erfindung;
- **Fig. 6**: Querschnittansicht durch die Kopplungseinheit und die Seitenwand des MRTs gemäß des ersten Ausführungsbeispiels der Erfindung;
- **Fig. 7**: Vorderansicht der Ventilelemente des ersten Ausführungsbeispiels der Erfindung;
- **Fig. 8**: Rückansicht der Ventilelemente des ersten Ausführungsbeispiels der Erfindung;
- **Fig. 9**: Perspektivische Darstellung einer zweiten, mobilen Ausführungsform 900 einer erfindungsgemäßen Entfüllungsvorrichtung;
- **Fig. 10**: perspektivisch ein weitere Darstellung der zweiten Ausführungsform 900 einer erfindungsgemäßen Entfüllungsvorrichtung.

In den Figuren sind gleichartige Elemente mit gleichen Bezugszeichen beziffert.

Es wird die Entfüllungsvorrichtung beschrieben für Verwendung als fest verbaute Vorrichtung, sowie die mobile Vorrichtung für den Einsatz vor Ort.

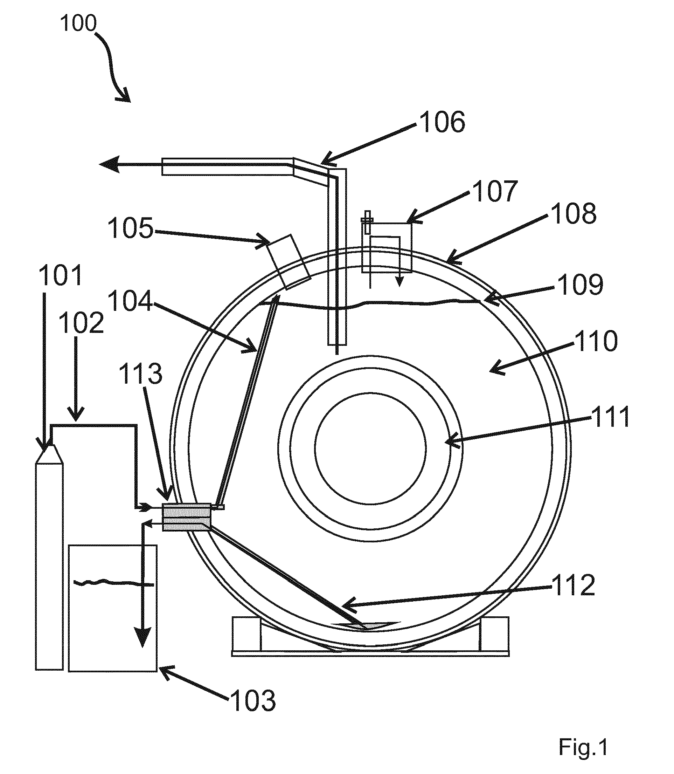

Fig. 1 beschreibt die Anordnung einer fest verbauten Ausführungsbeispiels 100 einer erfindungsgemäßen Vorrichtung im angeschlossenen Zustand. In der Fig. 1 ist die Funktion zum Ausleiten des flüssigen Helium-Bestandteils dargestellt. Durch Einleiten des Druckgases wird der Flüssigkeitsanteil durch die untere Leitung aus dem System herausgeführt. Besonders wesentlich sind die mit den Bezugszeichen 104, 113, 112 bezeichneten Elemente aus Figur 1. Die anderen Elemente dienen zur Verdeutlichung der Anordnung in der Anwendung an einem Tieftemperaturmagneten. Eine Hebergasflasche 101 wird benötigt, um einen Druckaufbau im Tieftemperaturmagneten zu erzeugen. Dieser Druck wird über die Zuführungsleitung 102 in den Eingang der Kopplungseinheit 113 geleitet. Das Hebergas drückt nun den Helium-Bestand 109 nach unten weg, der über die Hebergas-Steigleitung 104 zum gasförmigen Bestandteil führt und eingeleitet wurde. Durch die LHe-Sammelleitung 112 wird der flüssige Bestandteil des Heliums zur Kopplungseinheit 113 geleitet, an der durch eine weitere Leitung eine Dewarkanne / Transportkanne 103 angeschlossen ist. Sonstige Beschreibungen der Elemente 105, 106, 107, 108, 110, 111 unterscheiden sich je nach Bautyp und Hersteller des Tieftemperaturmagneten. Ein Befüllstutzen 105 dient in der Regel zur Befüllung des Magneten mit LHe (liquid Helium). Durch eine Notleitung 106 kann der gasförmige Teil bei Durchführung eines Quenchs nach außerhalb des Gebäudes geleitet wird. Durch den Kaltkopf 107 wird der gasförmige Teil des Helium wieder in den flüssigen Zustand und dem Kreislauf zurückgeführt wird. Der Kaltkopf 107 definiert in der Regel die höchste Stelle im Inneren des MRT-Containers. Die magnetische Abschirmung 108 ist von einem oft bei Tieftemperatur verwendete Active-Shield Typ, bzw. kompatible Bauweisen, der eine gewisse Abschirmung des Magneten erzeugt. Das Helium-Reservoir 110 unterscheidet sich je nach Hersteller und Typ, z.B. in der Füllmenge ca. 2500 Liter bis ca. 4500 Liter LHe (Liquid Helium) und mehr variieren kann. Die Gradientenspule 111 erzeugt das Magnetfeld, das im medizinischen Bereich zwischen ca. 0.5 bis ca. 3.0 Tesla magnetische Flussdichte, die sich bei Forschungsmagneten im Bereich zwischen ca. 7.0 und 9.0 Tesla magnetischer Flussdichte und mehr bewegen kann.

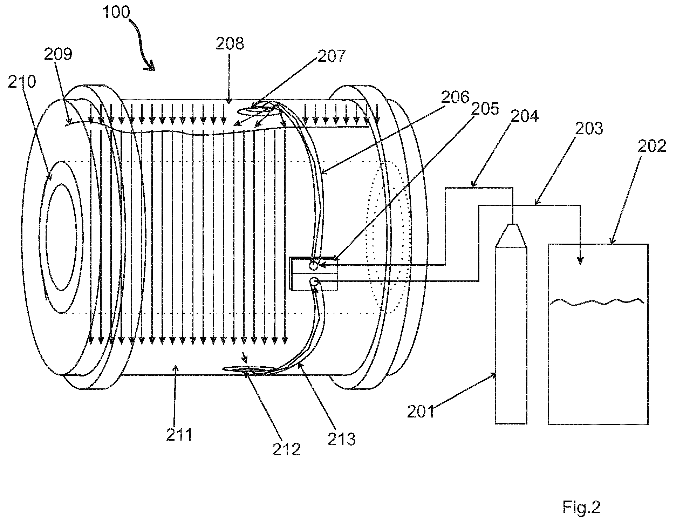

Fig. 2 zeigt ein erstes Ausführungsbeispiel 100 als räumliche Darstellung einer fest verbauten LHe-Entfüllungsvorrichtung. Dies ist die räumliche schematische Darstellung der Vorrichtung. Anhand von Pfeilen kann man erkennen, dass der im oberen Bereich aufgebaute Druck die Flüssigkeit nach unten drückt und somit das flüssige Helium aus dem System herausführt. Relevant sind die mit den Bezugszeichen 205, 205, 207, 212 und 213 benannten Elemente. Die anderen Nummern dienen wie in Fig. 1 zur Erklärung der Vorrichtung. Mit der Hebergasflasche 201 wird Heliumdampf, d.h. Druckgas, über die Hebergas-Zuführungsleitung 204 in die Kopplungseinheit 205 geleitet. Das Druckgas wird nun durch die Hebergas-Steigleitung 206 innerhalb des LHe-Reservoirs in die Leitungsöffnung 207 geleitet, in der es sich im Reservoir 208 ausbreitet und einen Druckaufbau hervorruft. Dieser Druck drückt nun bei geöffneter Kopplungseinheit 205 über den Abfluss 212 durch die LHe-Sammelleitung 213 das flüssige Helium über die angeschlossene Sammelleitung 213 in den bereitgestellten Transportbehälter 202. Durch den aufgebauten Druck im Reservoir 208 und des geöffneten Abflusses 212 kann nun der Pegel 209 kontrolliert gesenkt werden, um die Flussdichte der Magnetspulen 210 zu senken, um z.B. durch Personalfehlverhalten eingebrachte metallische Objekte aus den Magnetspulen 210 zu entfernen. Bei Außerbetriebnahme des Tieftemperatur-Magneten wird der Pegel vom Stand 209 auf den Minimalpegel 211 abgesenkt, um die Transportfähigkeit zu erreichen.

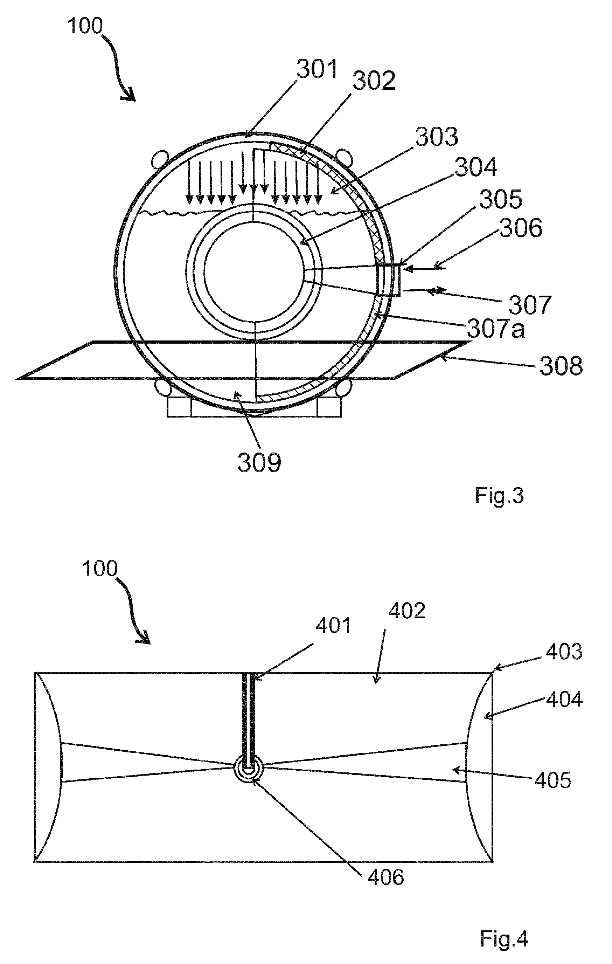

Fig. 3 und Fig. 4 sind in Abhängigkeit zueinander zusehen, wobei Fig. 4 eine Schnittzeichnung von der Draufsicht der Schnittebene 308 ist. Durch Einleitung wird Druckaufbau hervorgerufen, der das Helium in flüssiger Form nach unten durch die vorgesehenen Leitungen aus dem Tieftemperaturmagneten herausführt. Relevant sind die Elemente mit den Bezugszeichen 302, 305, 306, 307, 307a. Die anderweitigen Nummerierungen sind für die Funktionsaufbaubeschreibung notwendig. Über die Kopplungseinheit 305 wird das Druckgas durch die Hebergas-Zuführungsleitung 306 in die Hebergas-Steigleitung 302 eingeleitet. Dieser sammelt sich im LHe-Reservoir 301 und drückt den Pegel 303 durch die LHe-Sammelleitung 307a aus dem LHe-Reservoir 301 durch die Kopplungseinheit 305 in die LHe-Abführleitung 307a, die das Helium in einen Transportbehälter führt. Die Schnittebene 308 in der Fig. 4 verdeutlicht die Gradientenspule 304, sowie ermöglicht einen Blick auf den Abfluss 309.

In der Fig. 4 ist eine Schnittansicht auf den Boden mit der Draufsicht auf den Abfluss 406 dargestellt. Durch diesen Abfluss 406 wird das flüssige Helium aus dem MR-Reservoir herausführt. Fig. 4 beschreibt die Schnittansicht durch den unteren Teil des MR, in das LHe-Reservoir. Relevant sind die Elemente mit den Bezugszeichen 401, 405 und 406. Die anderweitigen Elemente 402, 403, 404 und 405sind zur Verdeutlichung aufgeführt. Das flüssige Helium, das sich im Reservoir 402 befindet, wird über den Abfluss 406 durch die LHe-Abführleitung 401 herausführt. Die Schräge 405 sorgt für einen besseren Abfluss. Die Außenkante 403 und Kreiswand 404 beschreiben den Active-Shield LHe-Behälter.

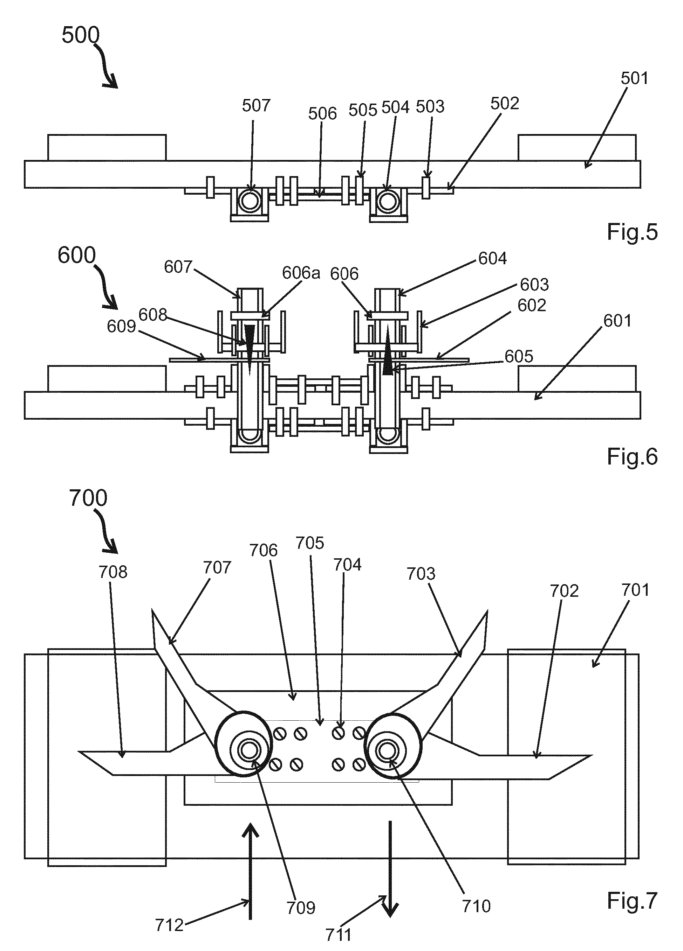

Fig. 5, Fig. 6 und Fig. 7 beschreiben die Kopplungseinheit im Detail. Für die Patentansprüche werden bei Fig. 5 sind alle Elemente bis auf das Element mit Bezugszeichen 501 als relevant angesehen. In Fig. 6 werden alle Elemente außer dem Element mit Bezugszeichen 601 als relevant angesehen. Für die Ausführung nach Fig. 7 werden alle Elemente außer dem Element mit Bezugszeichen 501, 601, 701 als relevant angesehen. Bei Fig. 5, Fig. 6 und Fig. 7, ist das Element mit der Bezugszeichen 501, 601 bzw. 701 eine Schnittdarstellung durch eine Wandung des Active-Shielded Behältnis, bzw. eine Sicht auf die Wandung 701 in Fig. 7.

Fig. 5 beschreibt eine Schnittansicht durch die Seitenwand eines Tieftemperaturmagneten an einer Kopplungseinheit 500. Hier kann man erkennen, dass die Verschraubungen / Nieten / Befestigungen die gasführende Leitung in Position halten. Fig. 5 zeigt die Schnittansicht, auf der Innenseite der Rohrführungen. Gezeigt wird hier die zuführende Leitung für das Hebergas 507, und die Helium herausführende LHe-Abführleitung 504. Die Leitungen werden entweder durch Schrauben oder Nieten 503, 505 fixiert, um den höchstmöglichen Abstand zur Magnetspule zu erzielen. Eine Abstandsplatte 506 ist erforderlich um einen Mindestabstand zwischen der Hebergas-Zuführungsleitung 507 und der LHe-Abführleitung 504 zu definieren. Diese Abstände sind fixiert durch die Verschraubungen / Nieten 505 die das Doppelte der Länge der Schrauben/Nieten 503 besitzen müssen, da zwei identische Platten 502 und 506 mit gleichen Dicken übereinander liegen.

Die Fig. 6 zeigt einen Querschnitt durch eine Kopplungseinheit 600 in verbautem Zustand. Hier ist der Bereich, an dem das gasförmige Gas und das flüssige Gas hineingeführt, bzw. herausgeführt werden, dargestellt. Ebenso sind die Sicherheitsventile zu sehen, die sich nur dann bewegen lassen, wenn die Heberleitungen mit dem Flansch verbunden wurden. Fig. 6 zeigt den kompletten Querschnitt durch die Kopplung. Die LHe-Abführleitung 604 und die Hebergas-Zuführungsleitung 607 sind bereits in Fig. 5 dargestellt. Die Richtungspfeile 605 und 608 beschreibt die jeweilige Flussrichtung der Gase. Der Sicherheitsmechanismus umfassend die Sicherheits-Verriegelungselemente 603, 606 und 606a sorgt dafür, dass die Ausström-Ventilhebel 602 und 609 genau dann betätigt werden können, wenn die Abflussleitungen und Zuflussleitungen angeschlossen sind. Zusätzlich befinden sich wie in Fig. 5 auch auf der Gegenseite, d.h. außen-liegenden Seite Verschraubungen 503, 506, um die Hebel und Sicherheitsmechanismen zu halten.

Die Fig. 7 zeigt eine Vorderansicht einer Kopplungseinheit 700 in zwei Zuständen, den geöffneten und den geschlossenen. Sind die Ventilhebel 702, 708 in der waagerechten Position, so sind die Schraubengewinde geschlossen, und ein Durchtreten der Gase nicht möglich. Ein Betätigen der Ventilhebel 702, 708 ohne angeschlossene Zu- und Abführungsleitung ist aus Sicherheitsgründen nicht möglich. Sind an den Hebeln Zu- und Abführungsleitung angeschlossen, lassen sich diese nach oben bewegen, in eine senkrechte Position 703, 707. Dann sind die Schraubengewinde geöffnet, und das Druckgas kann einströmen und gleichzeitig kann das flüssige Helium abgeführt werden. Fig. 7 beschreibt zwei Betriebszustände der Vorrichtung. Hebelposition 707 und 703 zeigen den geöffneten Zustand der Hähne. Dieser Zustand kann nur funktionieren, wenn die Hebergas-Zu- und LHe-Abführleitungen 709 und 710 angeschlossen sind. Erst dann lassen sich die Gewinde-Hebel bewegen. Die Zuführung des Druckgases wird durch den Pfeil 712 beschrieben. Die Abführung des flüssigen Heliums wird durch den Pfeil 711 beschrieben. Die Abstandsplatte 706 sorgt für ausreichenden Abstand der Hebel mit der Kopplungseinheit-Grundplatte 705 und den Verwendeten Schrauben / Nieten 704. Werden die beiden Hebel in die Schließpositionen 702 und 708 gebracht, ist eine Zuführung von Druckgas und Abführung von flüssigem Helium nicht mehr möglich. Dies ist von großer Bedeutung, wenn beispielsweise eine volle Dewarkanne / Transportbehälter durch einen leeren Transportbehälter getauscht werden muss. Gleiches gilt auch für die Hebergas-Flasche. Die Hebel 702/703 und 707/708 sind unabhängig voneinander zu betätigen. Es ist aber aus Sicherheitsgründen empfohlen bei Tausch einer der beiden Komponenten (Transportkanne, Hebergas / DruckgasFlasche) beide Hebel auf die geschlossene Position 708 und 702 zu bringen, um einen unkontrollierten Überdruck durch die Verschwenkung in die Verschlussposition 707 und Position 702 zu verhindern.

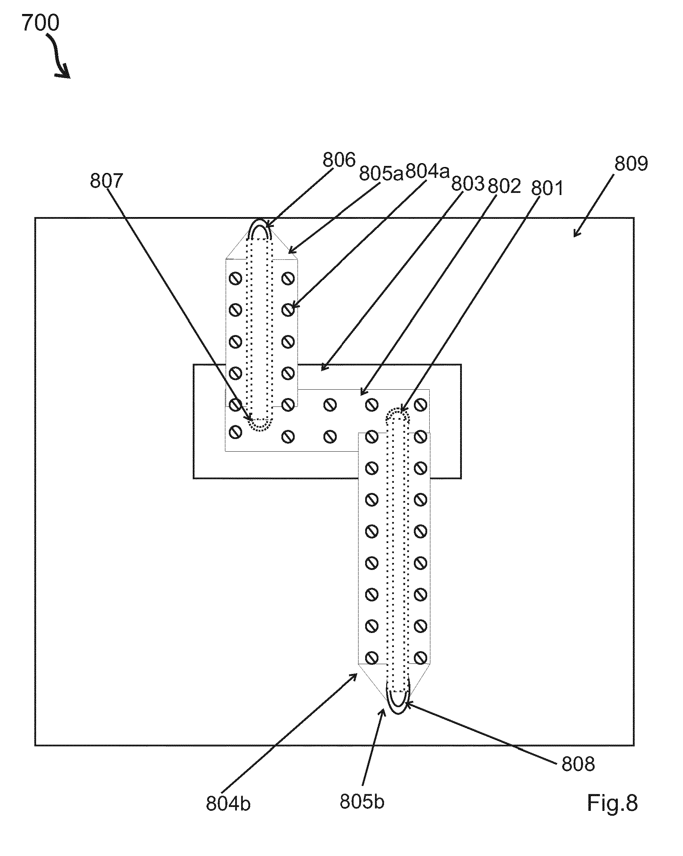

Fig. 7 und Fig. 8 sind wieder in Kombination zueinander zu sehen und stellen eine Kopplungseinheit 700 dar. Fig. 7 zeigt die Frontdarstellung und Fig. 8 eine Rückansicht der Kopplungseinheit 700. In der Fig. 8 wird die Positionen der Leitungen auf einer Innenwand eines MRT-Zylinders verdeutlicht. Durch Herbeiführen des Drucks auf der linken Seite (nach oben zeigend) wird das Helium aus dem MR-Reservoir herausgeführt (rechte Seite, nach unten zeigend). Relevant sind alle Element bis auf das Element mit Bezugszeichen 809, dass sich auf eine magnetische Abschirmung mit Active-Shield bzw. ein kompatibles System bezieht. Durch das Druckgas, das durch die Hebergas-Steigleitung 806 von dem Hebergas-Einführungsstutzen 807 zugeführt wird, wird durch den Druck das flüssige Helium durch die LHe-Sammelleitung 808 zum LHe-Entnahmestutzen geführt, der an den Transportbehälter angeschlossen ist. Die Leitungsführungsplatten 804a, 804b positioniert die Leitungen 806 und 808 mit der Verschraubungsplatte / Befestigungsplatte 803 und der Abstandsplatte 802. Die Leitungsführungsplatten 804a, 804b sind im gleichen Abstand zu befestigen. Am Übergangsbereich 805a, 805b gehen die Leitungsführungsplatten 804a, 804bt in die Leitungen 806, 808 über.

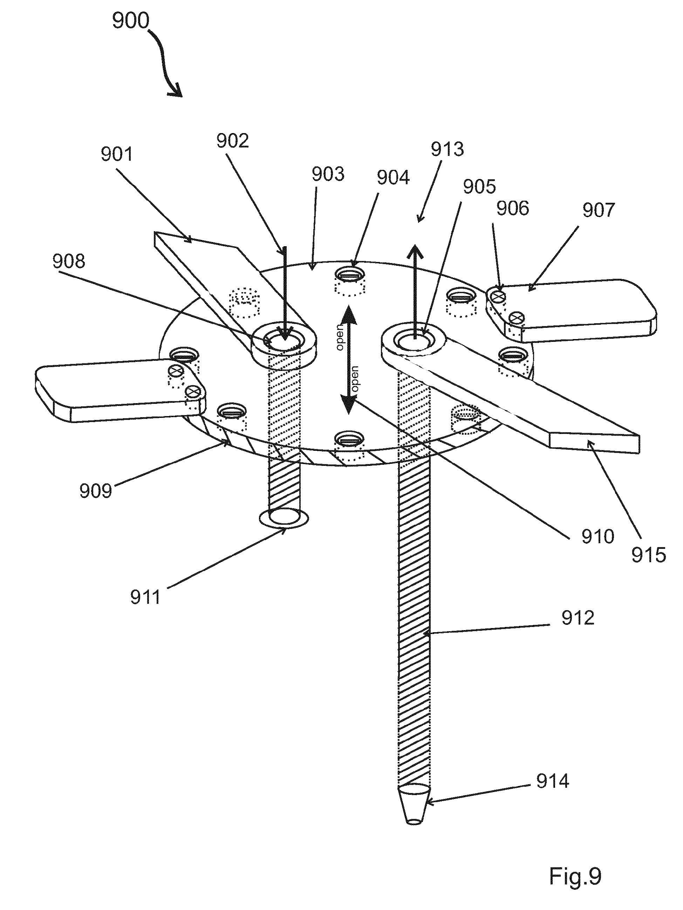

Fig. 9 beschreibt ein Ausführungsbeispiel 900 einer mobilen Kopplungseinheit für alle Systeme, die nicht mit einer stationären Kopplungseinheit ausgestattet sind. Es wird eine Ausführungsform 900 einer mobilen Vorrichtung dargestellt, die beispielsweise an einen Flansch einer aus dem Stand der Technik bekannten MRT-Röhre angebracht werden kann. Diese kann an Stelle des Befüllungsdeckels mit den Anschlüssen gesetzt bzw. anstatt des Kaltkopfes moniert. Es ist auch denkbar, dass eine ringförmige Adapterplatte eingesetzt wird, um die Kopplungseinheit an Flansche verschiedener Durchmesser und Geometrie anzupassen. Die im MR bestehenden Leitungen werden hierfür verwendet, um Druckaufbau zu erzeugen und das Helium aus dem Reservoir zu führen. Bei älteren Geräten oder anderen Bauweisen sind die Anschlüsse unterschiedlich in der Länge, daher kann für die Kopplungsplatte die jeweils benötigte Leitungsart verwendet werden, entweder starr, flexibel, mit Schraubengewinde oder mit Kegelaufsatz für unterschiedliche Flanschdicken im Durchmesser.

Hier werden alle bezeichneten Elemente als relevant angesehen. Ein Pfeil 902 beschreibt die Zuleitungsrichtung des Hebergases aus der Hebergasflasche. Der Pfeil 913 beschreibt die Strömrichtung des flüssigen Heliums durch die LHe-Abführleitung. Die gesamte Einheit 900 aus Fig. 9 sollte vorzugsweise aus unmagnetischem Material, insbesondere aus Titan oder unmagnetischem Stahl gefertigt werden. Die Einheit 900 kann über Tragegriffe 907 transportiert und für die Montage gehalten. Diese Tragegriffe 907 sind durch Griffbefestigungsmittel 906, in diesem Fall Schrauben, fest an einer kreisförmigen Platte 903 verschraubt. Die Platte 903 wird anstelle einer Befüllungs-Einheit oder einem Kaltkopf am Tieftemperaturmagneten durch Flanschbefestigungsmittel 904, in diesem Fall ebenfalls Schrauben, befestigt. Zwischen Flansch und Platte 903 ist in der Regel eine Abdichtung angeordnet. Gewindeventile 905, 908 lassen sich wie bei einer festen Einheit genau dann mittels Ventilverstellhebel 901, 915 öffnen, wenn die Zu- und Abführleitungen angeschlossen sind. Eine ÖffnungsBewegungsrichtung wird durch eine Beschriftung 910 der Verstellrichtungen mit Pfeilen 'open' vorgegeben. Die Grundplatte 903 kann für den jeweiligen MR-Typ in unterschiedlichen Radien 909 gefertigt werden, oder verschiedene Ringplatten können als Adapter zur Anpassung an verschiedene Durchmesser dienen. Vor Aufsetzen der Vorrichtung muss eine Hebergasleitung 911 am Aufsatz des inneren Systems angeschlossen werden, sodass der Sammelkegel 914 das LHe über eine Sammelleitung 912 entnommen werden kann. Die Leitungen 911 und 912 sind flexibel und in der Länge variabel, um an verschiedene MRT-Ausführungen und innere Geometrien angepasst werden zu können. Magneten ohne inneres Leitungs-System können auf die Hebergas-Steigleitung 911 verzichten, da der Druckaufbau direkt aufgebaut werden kann. Hierbei kann die LHe-Sammelleitung 912 so lang gewählt werden, dass diese bis auf den Boden des LHe-Reservoirs durchgeschoben werden kann. Hierbei ist insbesondere wichtig, dass die Sammelleitung 912 flexibel ausgeführt ist, um durch die innere komplexe und gekrümmte Geometrie des MR-Zylinders geführt werden zu können. Der Sammelkegel 914 sollte eine relativ große Öffnung zur Absaugung des flüssigen Heliums am Boden des Heliumreservoirs aufweisen und sollte eine hohe spezifische Masse aufweisen. Vorzugsweise ist der Sammelkegel 914 aus Titan oder unmagnetischem Stahl gefertigt.

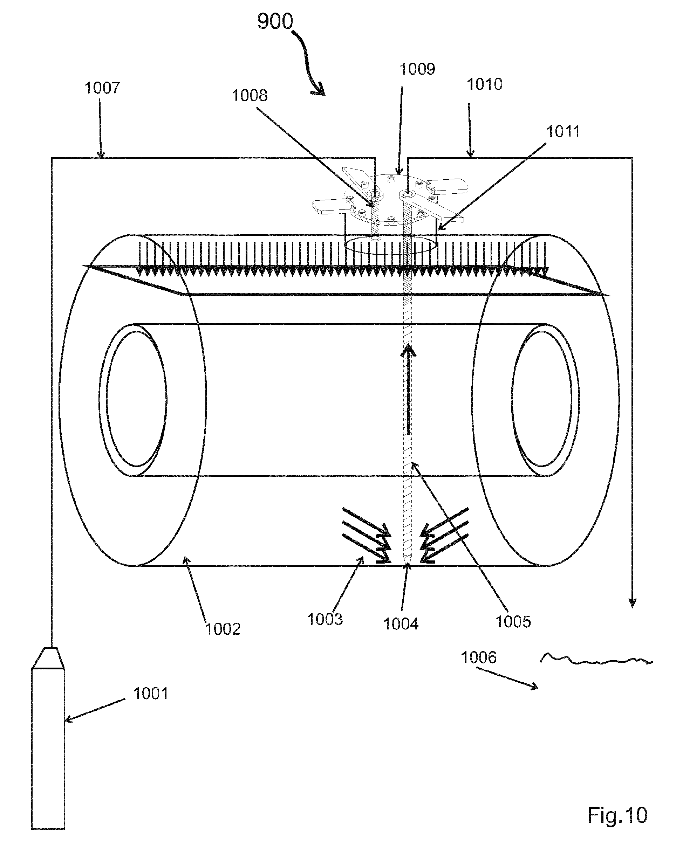

Fig. 10 beschreibt einen Einsatz 1008 der mobilen Kopplungseinheit aus Fig. 9. Diese Darstellung zeigt eine schematische Anwendung der Kopplungseinheit 1008 in der mobilen Bauweise. Nach der Verschraubung der Kopplungseinheit 1008 auf einen Flansch 1011 des MRT-Gehäuses des Containers 1002 wird der Druck über eine Hebergas-Zuführungsleitung 1007 eingeleitet, und es kann parallel dazu der flüssige Anteil Helium aus dem Tieftemperaturmagneten entnommen werden. Diese schematische Darstellung basiert auf eine Anwendung bei einem alten MRT, der noch über kein inneres Leitungssystem verfügt. Hier wird besonderer Wert auf die Elemente mit den Bezugszeichen 1004, 1005, 1008 und 1009 gelegt. Die Elemente mit den Bezugszeichen 1001, 1002, 1003, 1006, 1007, 1010 dienen hier zur Verdeutlichung der Vorrichtung in Anwendung. Über die Hebergas-Flasche 1001 wird mit der Hebergas-Zuführungsleitung 1007 das Hebergas über die Kopplungseinheit 1008 in den Tieftemperaturmagneten eingeleitet. Der entstehende Druck im Container 1002 drückt das flüssige Helium 1003 über die eingeschobene, flexible und schlauchförmige LHe-Sammelleitung 1005 durch den Sammelkegel 1004 an einer Entnahmestelle (tiefster Punkt im Container 1002), Grundplatte 1003 der Kopplungseinheit 1008 an der LHe-Abführleitung 1010 durch die Kopplungseinheit 1008 in einen Transportbehälter / Dewarkanne 1006.

Die Helium-Entfüllvorrichtung wird in einer stationären, fest verbauten Variante und einer Kopplungseinheit für eine mobile Variante vorgeschlagen. Die Liquid Helium Rückführungsvorrichtung umfasst jeweils zwei Führungsleitungen, die dazu dienen, über einfache Art und Weise flüssiges Gas, d.h. flüssiges Helium aus Tieftemperaturmagneten herauszuholen, und in Transportbehältnisse zu überführen. Die Vorrichtung in der mobilen Variante kann dazu genutzt werden, um den Heliumstand soweit abzusenken, dass das Magnetfeld schwächer wird. Wenn das Magnetfeld schwächer wird, wird es möglich, metallische Fremdkörper aus der Gradientenspule zu entfernen. Vorteil ist nach wie vor, dass das entnommene Helium auf gleiche Weise in umgekehrter Richtung dem System wieder zugefügt werden kann. Das spart erhebliche Kosten im Falle eines manuell hervorgerufenen Quench, und der Tieftemperaturmagnet kann am gleichen Tage wieder in Betrieb genommen werden. Die Tatsache, dass der Magnet am gleichen Tage wieder einsatzbereit ist, spart ebenfalls immense Kosten, da es in dem Fall keine Stillstandzeit gibt, bis wieder ausreichend Helium vorhanden ist, um ein Downcooling der Magnetspule sowie wieder Auffüllung auf optimalen Pegel durchzuführen. Die Vorrichtung im fest verbauten Zustand kann von jedem Kryostat-Techniker bedient werden. Im Falle eines Vorfalls, braucht der Techniker lediglich dafür Sorge zu tragen, dass genügend Transportbehälter und Druckgasflaschen vorhanden sind, um die Menge von ca. 3000 bis 4500 Liter flüssiges Helium umzufüllen, und hinterher wieder zu befüllen. Im Falle einer Außerbetriebnahme eines Gerätes, kann das Helium zurück in Transportbehälter überführt werden und anderweitigen Zwecken zur Verfügung gestellt werden. Die Kopplung zu bedienen über zwei Hähne ist sehr einfach, und löst dabei vielerlei Probleme auf einem Mal. Mit diesen Vorrichtungstypen gehört die Durchführung eines Quench der Vergangenheit an, und die Ressource Helium wird in soweit geschont, dass trotz immer mehr steigender Heliumknappheit z.B. bei Verwendung bei MRT-Anlagen, auch zukünftige Generationen davon profitieren können, eine strahlenfreie Untersuchungsmethode anwenden zu können.

### Bezugszeichenliste

- 100: LHe-Entfüllungsvorrichtung
- 101: Hebergasflasche
- 102: Hebergas-Zuführungsleitung
- 103: Transportbehälter
- 104: Hebergas-Steigleitung
- 105: Helium Befüllstutzen
- 106: Notleitung
- 107: Kaltkopf
- 108: magnetische Abschirmung
- 109: Helium-Bestand
- 110: Helium-Reservoir
- 111: Gradienten-Magnetspule
- 112: LHe-Sammelleitung
- 113: Kopplungseinheit

- 201: Hebergasflasche
- 202: Transportbehälter
- 203: LHe-Abführleitung
- 204: Hebergas-Zuführungsleitung
- 205: Kopplungseinheit
- 206: Hebergas-Steigleitung
- 207: Leitungsöffnung
- 208: Helium-Reservoir
- 209: Reservoirpegel
- 210: Gradienten-Magnetspule
- 211: Minimalpegel
- 212: Abfluss
- 213: LHe-Sammelleitung

- 301: Helium-Reservoir
- 302: Hebergas-Steigleitung
- 303: Helium-Pegel
- 304: Gradienten-Magnetspule
- 305: Kopplungseinheit
- 306: Hebergas-Zuführungsleitung
- 307: LHe-Abführleitung
- 308: Schnittebene
- 309: Abfluss

- 401: LHe-Abführleitung
- 402: Helium-Reservoir
- 403: Außenkante
- 404: MRT-Kreiswand
- 405: Schräge
- 406: Abfluss

- 500: Kopplungseinheit
- 501: MRT-Wandung
- 502: Kopplungseinheit-Grundplatte
- 503: kurze Schrauben / Nieten
- 504: LHe-Abführleitung
- 505: Lange Schrauben / Nieten
- 506: Abstandsplatte
- 507: Hebergas-Zuführungsleitung

- 600: Kopplungseinheit
- 601: MRT-Wandung
- 602: LHe-Ausström-Ventilhebel
- 603: Sicherheits-Verriegelungselement
- 604: LHe-Abführleitung
- 605: LHe-Abführrichtung
- 606: Sicherheits-Verriegelungselement
- 607: Hebergas-Zuführungsleitung
- 608: Hebergas-Einströmrichtung
- 609: Hebergas-Einström-Ventilhebel

- 700: Kopplungseinheit
- 701: MRT-Wandung
- 702: Ausström-Ventilhebel - geschlossener Zustand
- 703: Ausström-Ventilhebel - geöffneter Zustand
- 704: Befestigungselemente - Schrauben / Nieten
- 705: Kopplungseinheit-Grundplatte
- 706: Abstandsplatte
- 707: Einström-Ventilhebel - geöffneter Zustand
- 708: Einström-Ventilhebel - geschlossener Zustand
- 709: Hebergas-Zuführungsleitung
- 710: LHe-Abführleitung
- 711: LHe-Abführungsrichtung
- 712: Hebergas-Zuführungsrichtung

- 801: LHe-Entnahmestutzen
- 802: Abstandsplatte
- 803: Verschraubungsplatte / Befestigungsplatte
- 804: Leitungsführungsplatte
- 805: Übergangsbereich
- 806: Hebergas-Steigleitung
- 807: Hebergas-Einführungsstutzen
- 808: LHe-Sammelleitung
- 809: Magnetische Abschirmung

- 900: Mobile Kopplungseinheit
- 901: Zuführ-Verstellhebel
- 902: Hebergas-Zuführungsrichtung
- 903: Grundplatte
- 904: Flanschbefestigungsmittel
- 905: LHe-Ausströmventil
- 906: Griff-Befestigungsmittel
- 907: Tragegriffe
- 908: Hebergas-Einströmventil
- 909: Radius der Grundplatte
- 910: "open"-Beschriftung
- 911: Hebergas-Steigleitung
- 912: LHe-Sammelleitung
- 913: LHe-Abführungsrichtung
- 914: Sammelkegel
- 915: Abführ-Verstellhebel

- 1001: Hebergasflasche
- 1002: MRT-Container
- 1003: Helium-Reservoir
- 1004: Sammelkegel
- 1005: LHe-Sammelleitung
- 1006: Transportbehälter
- 1007: Hebergas-Zuführungsleitung
- 1008: Kopplungseinheit
- 1009: Grundplatte
- 1010: LHe-Abführleitung
- 1011: Flansch des MRT-Containers

## Patentansprüche

1. Helium-Entfüllungsvorrichtung (100) zur Rückgewinnung von flüssigem Helium (Liquid Helium - LHe) (109, 110, 208, 301, 402,1003) aus Tieftemperaturmagneten (111, 210, 304) von Magnetresonanztomographiegeräten (MRTs), umfassend eine an einer Wandung (404, 501, 601, 701) eines MRT-Containers (1002) befestigte Kopplungseinheit (113, 205, 305, 500, 600, 700, 900, 1008) zur Ausbildung einer zweikanalige Anschlussstelle für eine Hebergas-Zuführungsleitung (102, 204, 306, 507, 607, 709, 1007) an eine Hebergasflasche (101, 201, 1001) und eine LHe-Abführleitung (203, 307, 401, 504, 604, 710, 1010) an einen temperaturisolierten Helium-Transportbehälter (103, 202, 1006), wobei die Kopplungseinheit (113, 205, 305, 500, 600, 700, 900, 1008) in Richtung des Containerinneren einen Anschluss oder eine Verbindung zu einer Hebergas-Steigleitung (104, 206, 302, 806, 911) in Richtung eines oberen Abschnittsbereichs des Containers (1002) des MRTs und einen Anschluss oder eine Verbindung zu einer LHe-Sammelleitung (112, 213, 808, 912, 1005) in Richtung eines unteren Abschnittsbereiches des Containers (1002) zur Sammlung und Abführung des Helium-Reservoirs (109, 110, 208, 301, 402, 1003) umfasst, **dadurch gekennzeichnet, dass** ausgehend von der Kopplungseinheit (113, 205, 305, 500, 600, 700, 900, 1008) im Inneren des MRT-Containers (1002) die LHe-Sammelleitung (112, 213, 808, 912, 1005) nicht parallel zur Hebergas-Steigleitung (104, 206, 302, 806, 911) verläuft, so dass die LHe-Sammelleitung (112, 213, 808, 912, 1005) von der Hebergas-Steigleitung (104, 206, 302, 806, 911) abgewinkelt verläuft, und einen geometrisch komplexen, abgewinkelten oder gekrümmten Führungsverlauf aufweist oder flexibel ausgelegt ist, um einer Rundung des Zylindermantel-Wandung (404, 501, 601, 701) des MRT-Containers (1002) in Richtung zu einem tiefsten Punkt (212, 309, 405) des Containers (1002) zu folgen und/oder dass ausgehend von der Kopplungseinheit (113, 205, 305, 500, 600, 700, 900, 1002) im Inneren des MRT-Containers (1002) die Hebergas-Steigleitung (104, 206, 302, 806, 911) einen geometrisch komplexen, abgewinkelten oder gekrümmten Führungsverlauf aufweist oder flexibel ausgelegt ist, um einer Rundung des Zylindermantels des MRT-Containers (1002) in Richtung eines höchsten Punktes (107) des MRT-Containers (1002) zu folgen.

2. Vorrichtung (100) nach einem der vorhergehenden Ansprüche, **dadurch gekennzeichnet, dass** die Vorrichtung (100) eine Grundplatte (903, 1009) umfasst, die an einem Flansch (1011) des MRT-Containers (1002), insbesondere eines Heliumeinfüllflansches befestigbar ist, wobei bevorzugt eine oder mehrere kreis- oder rechteckige Adapterringe umfasst sind, um die Grundplatte (903, 1009) an verschiedene Flanschgrößen anpassbar zu machen.

3. Vorrichtung (100) nach einem der vorhergehenden Ansprüche, **dadurch gekennzeichnet, dass** die Vorrichtung (100) eine Grundplatte (502, 705) umfasst, die einstückig und unlösbar an oder in der Wandung (404, 501, 601, 701) des MRT-Containers (1002), bevorzugt an einem Seitenwandabschnitt (404, 501, 601, 701) des MRT-Containers (1002) befestigt ist.

4. Vorrichtung (100) nach einem der vorhergehenden Ansprüche, **dadurch gekennzeichnet, dass** die Grundplatte (502, 705, 903, 1009) zwei Anschlüsse für die Hebergas-Zuführungsleitung (102, 204, 306, 507, 607, 709, 1007) und die LHe-Abführleitung (203, 307, 401, 504, 604, 710, 1010) umfasst, wobei die Anschlüsse durch eine Abstandsplatte (506, 706, 802) beabstandet und durch Befestigungsmittel (503, 505, 704, 904) an der Wandung (404, 501, 601, 701) des Containers (1002) bzw. an der Grundplatte (502, 705, 903, 1009) befestigt sind.

5. Vorrichtung (100) nach einem der vorhergehenden Ansprüche, **dadurch gekennzeichnet, dass** der Endbereich der LHe-Sammelleitung (112, 213, 808, 912, 1005) in eine Vertiefung, Schräge (405), einen rampenförmig definierten tiefsten Bereich oder Abflussbereich (212, 309) des Containerinnenraums geführt ist.

6. Vorrichtung (100) nach einem der vorhergehenden Ansprüche, **dadurch gekennzeichnet, dass** die Kopplungseinheit (113, 205, 305, 500, 600, 700, 900, 1008) zumindest ein Sicherheitsrückschlagventil umfasst, um Druck aus der Hebergas-Zuführungsleitung (102, 204, 306, 507, 607, 709, 1007) und/oder aus der Hebergas-Steigleitung (104, 206, 302, 806, 911) zu blockieren, so dass die Leitung gefahrlos anschließbar ist.

7. Vorrichtung (100) nach einem der vorhergehenden Ansprüche, **dadurch gekennzeichnet, dass** zumindest die LHe-Sammelleitung (112, 213, 808, 912, 1005) eine flexible Leitung, insbesondere eine Metallschlauchleitung, Gummileitung oder andere flexible Tieftemperaturleitung ist, die bevorzugt an der Einlassöffnung einen Sammelkegel (914, 1004) aufweist.

8. Vorrichtung (100) nach einem der vorhergehenden Ansprüche 1 bis 6, **dadurch gekennzeichnet, dass** die LHe-Sammelleitung (112, 213, 808, 912, 1005) eine fest an einer Innenwandung (404, 501, 601, 701) des MRT-Containers (1002) verlegte Leitung ist, die zu einem tiefsten Punkt ((212, 309, 405) des Containers (1002) geführt ist und/oder dass die Hebergas-Steigleitung eine fest an einer Innenwandung (404, 501, 601, 701) des MRT-Containers (1002) verlegte Leitung ist, die zu einem höchsten Punkt (107) des Containers (1002) geführt ist.

9. Vorrichtung (100) nach einem der vorhergehenden Ansprüche, **dadurch gekennzeichnet, dass** die Kopplungseinheit (113, 205, 305, 500, 600, 700, 900, 1002) ein zumindest händisch betätigbares Hebergas-Zuführventil (609, 908) und zumindest ein händisch betätigbares LHe-Abführventil (602, 905) umfasst.

10. Vorrichtung (100) nach Anspruch 9, **dadurch gekennzeichnet, dass** zumindest das Hebergas-Zuführventil (609, 908) und/oder das LHe-Abführventil (602, 905) ein Sicherheits-Verriegelungselement (603, 606) umfasst, das eine Betätigung erst nach Anschluss der Hebergas-Zuführungsleitung (102, 204, 306, 507, 607, 709, 1007) und/oder der LHe-Abführleitung (203, 307, 401, 504, 604, 710, 1010) ermöglicht.

## Claims

1. Helium emptying device (100) for retrieval of liquid helium (LHe) (109, 110, 208, 301, 402,1003) from low-temperature magnets (111, 210, 304) of magnetic resonance tomography units (MRTs), comprising a coupling unit (113, 205, 305, 500, 600, 700, 900, 1008) fastened to a wall (404, 501, 601, 701) of an MRT container (1002) in order to form a two-channel connection point for a siphon gas supply line (102, 204, 306, 507, 607, 709, 1007) on a siphon gas bottle (101, 201, 1001) and an LHe discharge line (203, 307, 401, 504, 604, 710, 1010) on a temperature-insulated helium transport vessel (103, 202, 1006), said coupling unit (113, 205, 305, 500, 600, 700, 900, 1008) comprising in the direction of the container interior a connection or link to a siphon gas riser (104, 206, 302, 806, 911) in the direction of an upper section area of the container (1002) of the MRT and a connection or link to an LHe collecting line (112, 213, 808, 912, 1005) in the direction of a lower section area of the container (1002) for collection and discharge of the helium reservoir (109, 110, 208, 301, 402, 1003), **characterized in that** starting from the coupling unit (113, 205, 305, 500, 600, 700, 900, 1008) inside the MRT container (1002) the LHe collecting line (112, 213, 808, 912, 1005) does not run parallel to the siphon gas riser (104, 206, 302, 806, 911), so that the LHe collecting line (112, 213, 808, 912, 1005) runs at an angle to the siphon gas riser (104, 206, 302, 806, 911) and has a geometrically complex, angled or curved course or is flexibly designed in order to follow a curvature of the cylinder jacket wall (404, 501, 601, 701) of the MRT container (1002) in the direction of a lowest point (212, 309, 405) of the container (1002) and/or that starting from the coupling unit (113, 205, 305, 500, 600, 700, 900, 1002) the siphon gas riser (104, 206, 302, 806, 911) in the interior of the MRT container (1002) has a geometrically complex, angled or curved course or is flexibly designed in order to follow a curvature of the cylinder jacket of the MRT container (1002) in the direction of a highest point (107) of the MRT container (1002).

2. Device (100) according to one of the preceding claims, **characterized in that** the device (100) comprises a baseplate (903, 1009) fastenable to a flange (1011) of the MRT container (1002), in particular a helium filling flange, where preferably one or more circular or rectangular adapter rings are provided to make the baseplate (903, 1009) adaptable to various flange sizes.

3. Device (100) according to one of the preceding claims, **characterized in that** the device (100) comprises a baseplate (502, 705) which is fastened in one piece and undetachably on or in the wall (404, 501, 601, 701) of the MRT container (1002), preferably on a side wall section (404, 501, 601, 701) of the MRT container (1002).

4. Device (100) according to one of the preceding claims, **characterized in that** the baseplate (502, 705, 903, 1009) comprises two connections for the siphon gas supply line (102, 204, 306, 507, 607, 709, 1007) and the LHe discharge line (203, 307, 401, 504, 604, 710, 1010), where said connections are kept apart by a spacer plate (506, 706, 802) and are fastened by fastening means (503, 505, 704, 904) to the wall (404, 501, 601, 701) of the container (1002) and to the baseplate (502, 705, 903, 1009) respectively.

5. Device (100) according to one of the preceding claims, **characterized in that** the end area of the LHe collecting line (112, 213, 808, 912, 1005) is passed into a recess, bevel (405), area defined with a ramp shape or drain-off area (212, 309) of the container interior.

6. Device (100) according to one of the preceding claims, **characterized in that** the coupling unit (113, 205, 305, 500, 600, 700, 900, 1008) comprises at least one safety non-return valve for blocking pressure from the siphon gas supply line (102, 204, 306, 507, 607, 709, 1007) and/or from the siphon gas riser (104, 206, 302, 806, 911), so that the line can be connected without risk.

7. Device (100) according to one of the preceding claims, **characterized in that** at least the LHe collecting line (112, 213, 808, 912, 1005) is a flexible line, in particular a metal hose line, rubber line or other flexible low-temperature line that preferably has a collecting cone (914, 1004) at the inlet opening.

8. Device (100) according to one of the preceding claims 1 to 6, **characterized in that** the LHe collecting line (112, 213, 808, 912, 1005) is a line permanently laid on an inner wall (404, 501, 601, 701) of the MRT container (1002) and passing to a lowest point (212, 309, 405) of the container (1002) and/or that the siphon gas riser is a line permanently laid on an inner wall (404, 501, 601, 701) of the MRT container (1002) passing to a highest point (107) of the container (1002).

9. Device (100) according to one of the preceding claims, **characterized in that** the coupling unit (113, 205, 305, 500, 600, 700, 900, 1002) comprises at least one manually operable siphon gas supply valve (609, 908) and at least one manually operable LHe discharge valve (602, 905).

10. Device (100) according to Claim 9, **characterized in that** at least the siphon gas supply valve (609, 908) and/or the LHe discharge valve (602, 905) comprises a safety locking element (603, 606), which permits operation only after connection of the siphon gas supply line (102, 204, 306, 507, 607, 709, 1007) and/or of the LHe discharge line (203, 307, 401, 504, 604, 710, 1010).

## Revendications

1. Dispositif de purge d'hélium (100) destiné à recycler de l'hélium liquide (Liquid Helium - LHe) (109, 110, 208, 301, 402, 1003) provenant d'aimants cryogéniques (111, 210, 304) de tomographes à résonance magnétique (TRM), ledit dispositif comprenant une unité de couplage (113, 205, 305, 500, 600, 700, 900, 1008) fixée à une paroi (404, 501, 601, 701) d'un conteneur de TRM (1002) afin de former un point de raccordement à deux voies pour une conduite d'alimentation en gaz refoulant (102, 204, 306, 507, 607, 709, 1007) sur une bouteille de gaz refoulant (101, 201, 1001), ainsi qu'une conduite d'évacuation de LHe (203, 307, 401, 504, 604, 710, 1010) sur un récipient de transport d'hélium isotherme (103, 202, 1006), sachant que l'unité de couplage (113, 205, 305, 500, 600, 700, 900, 1008) comprend en direction de l'intérieur du conteneur un raccordement ou une jonction à une conduite ascendante de gaz refoulant (104, 206, 302, 806, 911) en direction d'une partie de zone supérieure du conteneur (1002) du TRM, et un raccordement ou une jonction à un collecteur de LHe (112, 213, 808, 912, 1005) en direction d'une partie de zone inférieure du conteneur (1002) afin de collecter et évacuer le réservoir d'hélium (109, 110, 208, 301, 402, 1003), **caractérisé en ce qu'**en partant de l'unité de couplage (113, 205, 305, 500, 600, 700, 900, 1008) à l'intérieur du conteneur de TRM (1002), le collecteur de LHe (112, 213, 808, 912, 1005) ne s'étend pas parallèlement à la conduite ascendante de gaz refoulant (104, 206, 302, 806, 911), de sorte qu'en amont de la conduite ascendante de gaz refoulant (104, 206, 302, 806, 911), le collecteur de LHe (112, 213, 808, 912, 1005) s'étend suivant un angle et présente un tracé géométrique complexe, coudé ou incurvé, ou est conçu de manière flexible, afin d'épouser une rotondité de la paroi du corps cylindrique (404, 501, 601, 701) du conteneur de TRM (1002) en direction d'un point le plus bas (212, 309, 405) du conteneur (1002), et/ou qu'en partant de l'unité de couplage (113, 205, 305, 500, 600, 700, 900, 1002) à l'intérieur du conteneur de TRM (1002), la conduite ascendante de gaz refoulant (104, 206, 302, 806, 911) présente un tracé géométrique complexe, coudé ou incurvé, ou est conçue de manière flexible, afin d'épouser une rotondité du corps cylindrique du conteneur de TRM (1002) en direction d'un point le plus haut (107) du conteneur de TRM (1002).

2. Dispositif (100) selon l'une des revendications précédentes, **caractérisé en ce que** ledit dispositif (100) comprend une plaque de base (903, 1009) qui peut être fixée à une bride (1011) du conteneur de TRM (1002), en particulier à une bride de remplissage d'hélium, sachant que de préférence est/sont compris un ou plusieurs anneau(x) adaptateur(s) circulaire(s) ou rectangulaire(s) afin d'adapter la plaque de base (903, 1009) à différentes tailles de bride.

3. Dispositif (100) selon l'une des revendications précédentes, **caractérisé en ce que** ledit dispositif (100) comprend une plaque de base (502, 705), qui est fixée de manière indissociable à ou dans la paroi (404, 501, 601, 701) du conteneur de TRM (1002), de préférence à une partie de paroi latérale (404, 501, 601, 701) du conteneur de TRM (1002), et ce en formant une seule pièce avec ladite paroi.

4. Dispositif (100) selon l'une des revendications précédentes, **caractérisé en ce que** la plaque de base (502, 705, 903, 1009) comprend deux raccordements pour la conduite d'alimentation en gaz refoulant (102, 204, 306, 507, 607, 709, 1007) et la conduite d'évacuation de LHe (203, 307, 401, 504, 604, 710, 1010), sachant que les raccordements sont espacés par une plaque d'écartement (506, 706, 802) et fixés par des éléments de fixation (503, 505, 704, 904) à la paroi (404, 501, 601, 701) du conteneur (1002) et à la plaque de base (502, 705, 903, 1009) respectivement.

5. Dispositif (100) selon l'une des revendications précédentes, **caractérisé en ce que** l'extrémité du collecteur de LHe (112, 213, 808, 912, 1005) est introduite dans un creux, une déclivité (405), une zone au plus bas définie en forme de rampe ou une zone d'écoulement (212, 309) de l'intérieur du conteneur.

6. Dispositif (100) selon l'une des revendications précédentes, **caractérisé en ce que** l'unité de couplage (113, 205, 305, 500, 600, 700, 900, 1008) comprend au moins un clapet antiretour de sécurité afin de bloquer la pression provenant de la conduite d'alimentation en gaz refoulant (102, 204, 306, 507, 607, 709, 1007) et/ou de la conduite ascendante de gaz refoulant (104, 206, 302, 806, 911), si bien que la conduite peut être raccordée sans danger.

7. Dispositif (100) selon l'une des revendications précédentes, **caractérisé en ce qu'**au moins le collecteur de LHe (112, 213, 808, 912, 1005) présente une conduite souple, en particulier un tuyau métallique souple, un tuyau en caoutchouc ou autre conduite basse température souple, qui présente de préférence un cône collecteur (914, 1004) à l'orifice d'entrée.

8. Dispositif (100) selon l'une des revendications précédentes 1 à 6, **caractérisé en ce que** le collecteur de LHe (112, 213, 808, 912, 1005) est une conduite posée à demeure sur une paroi intérieure (404, 501, 601, 701) du conteneur de TRM (1002) et qui est amenée à un point le plus bas (212, 309, 405) du conteneur (1002), et/ou que la conduite ascendante de gaz refoulant est une conduite posée à demeure sur une paroi intérieure (404, 501, 601, 701) du conteneur de TRM (1002) et qui est amenée à un point le plus haut (107) du conteneur (1002).

9. Dispositif (100) selon l'une des revendications précédentes, **caractérisé en ce que** l'unité de couplage (113, 205, 305, 500, 600, 700, 900, 1002) comprend au moins une vanne d'alimentation en gaz refoulant (609, 908) actionnable à la main et au moins une vanne d'évacuation de LHe (602, 905) actionnable à la main.

10. Dispositif (100) selon la revendication 9, **caractérisé en ce qu'**au moins la vanne d'alimentation en gaz refoulant (609, 908) et/ou la vanne d'évacuation de LHe (602, 905) comprend un élément de verrouillage de sécurité (603, 606) qui n'autorise un actionnement qu'après raccordement de la conduite d'alimentation en gaz refoulant (102, 204, 306, 507, 607, 709, 1007) et/ou de la conduite d'évacuation de LHe (203, 307, 401, 504, 604, 710, 1010).
